# EUROPEAN PATENT APPLICATION

(11) **EP 4 811 281 A1**
(43) Date of publication of application: **23.09.2026**
(21) Application number: 26165087.3
(22) Date of filing: 16.03.2026
(51) Int. Cl.: G06T 7/00

(54) **SUBSTRATE PROCESSING METHOD, IMAGE COLLECTION METHOD, SUBSTRATE PROCESSING PROGRAM AND SUBSTRATE PROCESSING APPARATUS**

(30) Priority: 18.03.2025 JP 2025044128
(71) Applicant: SCREEN Holdings Co., Ltd., Kyoto-shi, Kyoto 602-8585 (JP)
(72) Inventor: CHAUHAN, Nachiketa, Kyoto, 602-8585 (JP); SHIMIZU, Shinji, Kyoto, 602-8585 (JP)
(74) Representative: Kilian Kilian & Partner mbB

(57) **Abstract**

A processing liquid is supplied to a substrate by a processing nozzle. A processing image showing the substrate to which the processing liquid is supplied is generated by an imaging device. An input image receiver receives a first input image showing a state of the processing liquid on the substrate when an abnormality occurs in a substrate process. Based on the first input image, a shape model generator generates a shape model representing a three-dimensional shape of the processing liquid supplied to the substrate. A simulation executor simulates a transition of a state of the processing liquid in the shape model. An image generator generates an image showing a transition of the state of the processing liquid in a simulation. A collector collects the generated image as an abnormal image. An abnormality detector detects an abnormality in the substrate process based on a comparison between the processing image and the abnormal image.

## Description

### BACKGROUND

### Technical Field

The present disclosure relates to a substrate processing method, an image collection method, a substrate processing program, and a substrate processing apparatus, each for collecting images.

### Description of Related Art

A substrate processing apparatus is used to execute various processes on various substrates such as a substrate for a flat panel display (FPD), a semiconductor substrate, a substrate for an optical disc, a substrate for a magnetic disc, a substrate for a magneto-optical disc, a substrate for a photomask, a ceramic substrate, or a substrate for a solar cell. The substrate processing apparatus may be provided with a function for detecting an abnormality in a substrate process. For example, in a substrate processing apparatus described in JP 2023-122222 A, a substrate is processed, according to a recipe, by supplying a processing liquid from a fixed nozzle to an upper surface of a substrate rotated by a spin chuck.

In the above-mentioned substrate processing apparatus, a camera is provided at a position where each component is within a field of view. An actual image is generated as the camera captures an image at a predetermined time. Further, a normal image is stored in advance in a storage of the substrate processing apparatus. The normal image is a still image obtained from a viewpoint located at the same position as the camera, and is generated by simulating a state of the substrate processing apparatus normally working according to the recipe based on three-dimensional design information. Based on the difference between the normal image and the actual image, an abnormality of each component of the substrate processing apparatus is detected.

### SUMMARY

The accuracy of detecting an abnormality in a substrate process using a liquid is considered to be improved by using images (hereinafter referred to as abnormal images) showing a transition of the processing liquid when an abnormality occurs in the substrate process using a liquid. However, the frequency of occurrence of abnormality in the process using a liquid is not so high. Further, it is not easy to intentionally cause an abnormality in the process using a liquid. Further, there are innumerable variations in a transition of the processing liquid when an abnormality occurs in the process using a liquid. Therefore, collecting a large number of abnormal images requires a huge amount of time, a workload, and cost.

An object of the present disclosure is to provide a substrate processing method, an image collection method, a substrate processing program, and a substrate processing apparatus, each enabling efficient collection of abnormal images.

A substrate processing method according to a first aspect of the present disclosure executed in a substrate processing apparatus, includes supplying a processing liquid to a substrate using a processing nozzle, generating, using an imaging device, a processing image showing the substrate to which the processing liquid is supplied, collecting an abnormal image showing a state of the processing liquid on the substrate when an abnormality occurs in a substrate process, and detecting the abnormality in the substrate process based on a comparison between the processing image and the abnormal image, wherein the collecting an abnormal image is executed by a processor, and the substrate processing method includes receiving a first input image showing a state of the processing liquid on the substrate when the abnormality occurs in the substrate process, generating, based on the first input image, a shape model representing a three-dimensional shape of the processing liquid supplied to the substrate, simulating a transition of the state of the processing liquid in the shape model, generating an image showing the transition of the state of the processing liquid in a simulation, and collecting the generated image as the abnormal image.

An image collection method according to a second aspect of the present disclosure of collecting, using a processor, an abnormal image for detecting an abnormality in a substrate process executed using a processing liquid, includes receiving a first input image showing a state of the processing liquid when an abnormality occurs in the substrate process, with the processing liquid being supplied to a substrate, generating, based on the first input image, a shape model representing a three-dimensional shape of the processing liquid supplied to the substrate, simulating a transition of the state of the processing liquid in the shape model, generating an image showing the transition of the state of the processing liquid in a simulation, and collecting the generated image as the abnormal image.

A substrate processing program according to a third aspect of the present disclosure executed in a substrate processing apparatus, causes a processor to supply a processing liquid to a substrate using a processing nozzle, generate, using an imaging device, a processing image showing the substrate to which the processing liquid is supplied, collect an abnormal image showing a state of the processing liquid on the substrate when an abnormality occurs in a substrate process, and detect the abnormality in the substrate process based on a comparison between the processing image and the abnormal image, wherein the causing a processor to collect an abnormal image includes causing the processor to receive a first input image showing a state of the processing liquid on the substrate when the abnormality occurs in the substrate process, generate, based on the first input image, a shape model representing a three-dimensional shape of the processing liquid supplied to the substrate, simulate a transition of the state of the processing liquid in the shape model, generate an image showing the transition of the state of the processing liquid in a simulation, and collect the generated image as the abnormal image.

A substrate processing apparatus according to a fourth aspect includes a processing nozzle that supplies a processing liquid to a substrate, an imaging device that generates a processing image showing the substrate to which the processing liquid is supplied, an input image receiver that receives a first input image showing a state of the processing liquid on the substrate when an abnormality occurs, a shape model generator that generates, based on the first input image, a shape model representing a three-dimensional shape of the processing liquid supplied to the substrate, a simulation executor that simulates a transition of the state of the processing liquid in the shape model, an image generator that generates an image showing the transition of the state of the processing liquid in a simulation, a collector that collects the generated image as an abnormal image, and an abnormality detector that detects the abnormality in the substrate process based on a comparison between the processing image and the abnormal image.

With the present disclosure, it is possible to efficiently collect abnormal images.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a diagram showing one example of the configuration of a substrate processing apparatus according to one embodiment of the present disclosure;
Fig. 2 is a diagram showing one example of the configuration of an image collection device;
Fig. 3 is a block diagram showing the functional configuration of the image collection device;
Fig. 4 is a diagram showing one example of input images;
Fig. 5 is a diagram showing one example of shape models;
Fig. 6 is a block diagram showing the functional configuration of a training device;
Fig. 7 is a block diagram showing the functional configuration of an abnormality detection device;
Fig. 8 is a flowchart showing one example of a flow of an image collection process;
Fig. 9 is a flowchart showing one example of a flow of a training process; and
Fig. 10 is a flowchart showing one example of a flow of an abnormality detection process.

### DETAILED DESCRIPTION

A substrate processing method, an image collection method, a substrate processing program and a substrate processing apparatus according to embodiments of the present disclosure will be described below with reference to the drawings. In the following description, a substrate refers to a semiconductor substrate (wafer), a substrate for a Flat Panel Display (FPD) such as a liquid crystal display device or an organic Electro Luminescence (EL) display device, a substrate for an optical disc, a substrate for a magnetic disc, a substrate for a magneto-optical disc, a substrate for a photomask, a ceramic substrate, a substrate for a solar cell, or the like.

### 1. Substrate Processing Apparatus

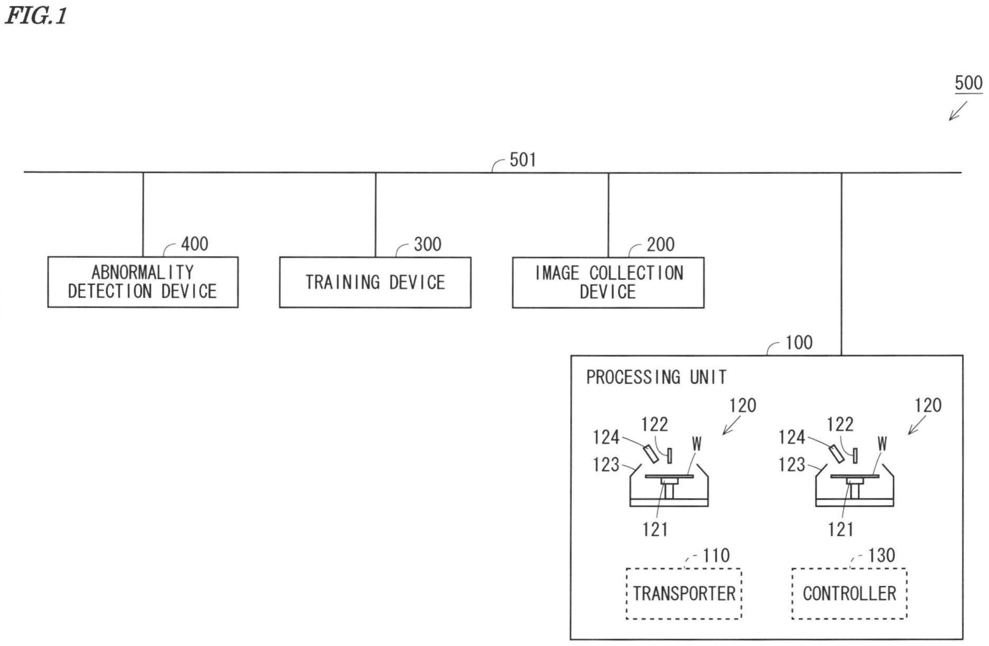

Fig. 1 is a diagram showing one example of the configuration of a substrate processing apparatus according to one embodiment of the present disclosure. As shown in Fig. 1, the substrate processing apparatus 500 includes a processing unit 100, an image collection device 200, a training device 300, and an abnormality detection device 400. The processing unit 100, the image collection device 200, the training device 300, and the abnormality detection device 400 are connected to a network 501, and can transmit and receive data to and from one another. As the network 501, a local area network (LAN) or a wide area network (WAN) may be used, for example. Alternatively, the network 501 may be the Internet. The network 501 may be connected through a wired connection or a wireless connection.

The processing unit 100 processes a substrate using a processing liquid. While being a cleaning process in the present example, a substrate process may be another process such as a coating process or a development process. The processing unit 100 includes a transporter 110, a plurality of processors 120, and a controller 130. The transporter 110 is a transport robot, for example, and sequentially carries unprocessed substrates W into any of the processing units 120 according to a processing recipe describing processing contents of the substrate W. Further, the transporter 110 carries out a processed substrate W from each of the processors 120 according to the processing recipe.

Each processor 120 includes a spin chuck 121, a processing nozzle 122, a processing cup 123, and an imaging device 124. The spin chuck 121 holds a carried-in substrate W in a substantially horizontal posture and rotates the held substrate W about a vertical axis. The processing nozzle 122 discharges the processing liquid to the center of the upper surface of the substrate W rotated by the spin chuck 121. In the present example, the processing liquid is isopropyl alcohol (IPA). The processing liquid that has been discharged to the center of the upper surface of the rotating substrate W spreads on the upper surface of the substrate W due to a centrifugal force, whereby a liquid film of the processing liquid is formed on the upper surface of the substrate W.

The processing cup 123 is provided to surround the spin chuck 121, and receives the processing liquid shaken off outwardly from the rotating substrate W. The processing liquid that has been received by the processing cup 123 is guided to a waste liquid device (not shown) to be discarded. The liquid film on the upper surface of the substrate W dries by gradually breaking. During a step of drying the substrate W, gas may be supplied to the substrate W or thermal adjustment of the substrate W may be performed. A broken area (dry area) of the liquid film is referred to as a break. Foreign matter is removed and the substrate W is cleaned as a break spreads over the entire upper surface of the substrate W. The imaging device 124 generates an image (hereinafter referred to as a processing image) showing the shape of the break that spreads on the upper surface of the substrate W by capturing an image of the upper surface of the substrate W during a substrate process.

The controller 130 includes a hardware processor such as a central processing unit (CPU), a micro processing unit (MPU), a graphics processing unit (GPU), or a digital signal processor (DSP). The controller 130 may include a combination of two or more hardware processors described above, or may include a field-programmable gate array (FPGA) or an application specific integrated circuit (ASIC). The controller 130 controls the works of the transporter 110 and each processor 120. Further, the controller 130 acquires a processing image from the imaging device 124 of each processor 120 and provides the processing image to the abnormality detection device 400.

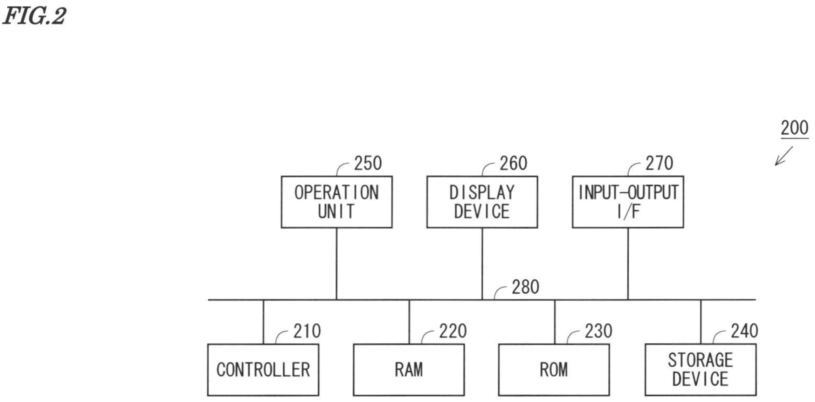

The image collection device 200 may include a general-purpose computer, for example. Fig. 2 is a diagram showing one example of the configuration of the image collection device 200. As shown in Fig. 2, the image collection device 200 includes a controller 210, a random access memory (RAM) 220, a read only memory (ROM) 230, a storage device 240, an operation unit 250, a display device 260, an input-output interface (I/F) 270, and a bus 280. The controller 210, the RAM 220, the ROM 230, the storage device 240, the operation unit 250, the display device 260, and the input-output I/F 270 are connected to the bus 280.

The controller 210 includes a hardware processor similar to that of the controller 130 of the processing unit 100. The RAM 220 is used as a work area for the controller 210. A system program is stored in the ROM 230. The storage device 240 includes a storage medium such as a hard disc or a semiconductor memory, and stores an image collection program. The image collection program is part of the substrate processing program, and causes the controller 210 to execute an image collection process, described below. The image collection program may be stored in the ROM 230 or may be stored in another external storage device such as an SD memory card or a compact disc (CD)-ROM.

The operation unit 250 is an input device such as a keyboard, a mouse, or a touch panel. A user of the substrate processing apparatus 500 can input various types of information to the controller 210 by operating the operation unit 250. The display device 260 is a display device such as a liquid crystal display device and displays a graphical user interface (GUI) or the like for receiving the information input by the user. The input-output I/F 270 is connected to the network 501 of Fig. 1.

Each of the training device 300 and the abnormality detection device 400 of Fig. 1 includes a general-purpose computer, for example. Thus, each of the training device 300 and the abnormality detection device 400 basically has the same configuration as that of the image collection device 200 except for the following points. For this reason, the detailed hardware configurations of the training device 300 and the abnormality detection device 400 will not be described.

A storage device of the training device 300 stores a training program. The training program is part of the substrate processing program, and causes a controller of the training device 300 to execute a training process, described below. The training program may be stored in a ROM of the training device 300 or another external storage device. A storage device of the abnormality detection device 400 stores an abnormality detection program. The abnormality detection program is part of the substrate processing program, and causes a controller of the abnormality detection device 400 to execute an abnormality detection process, described below. The abnormality detection program may be stored in a ROM of the abnormality detection device 400 or another external storage device.

At least some of the constituent elements of the image collection device 200, the training device 300, and the abnormality detection device 400 may be realized by common hardware. In this case, the image collection device 200, the training device 300, and the abnormality detection device 400 have the different substrate processing programs to be installed. Thus, the image collection device 200, the training device 300, and the abnormality detection device 400 execute different processes.

### 2. Image Collection Device

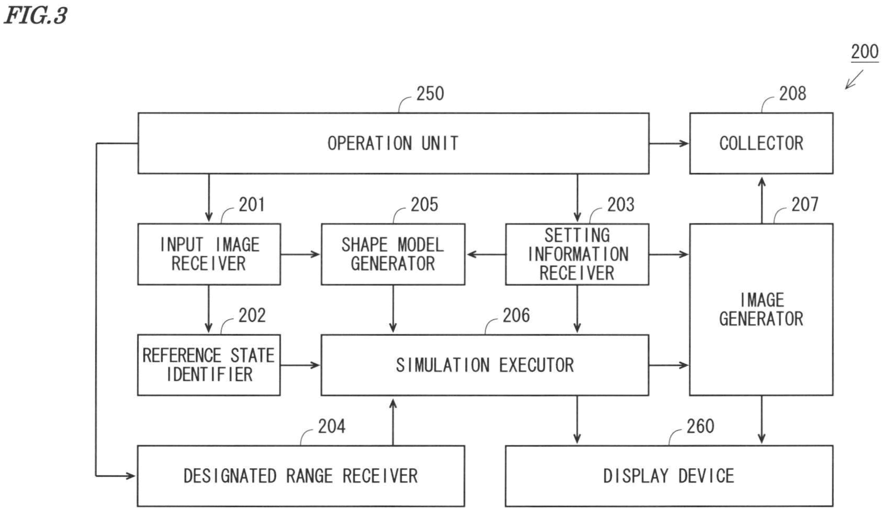

The image collection device 200 receives, as an input image, the image showing a shape of a break when an abnormality occurs in a liquid process. Further, the image collection device 200 simulates a transition of the break shown in the received input image, thereby collecting abnormal images showing shapes of other breaks when the abnormality occurs in the liquid process. Fig. 3 is a block diagram showing the functional configuration of the image collection device 200.

As shown in Fig. 3, the image collection device 200 includes, as functions, an input image receiver 201, a reference state identifier 202, a setting information receiver 203, a designated range receiver 204, a shape model generator 205, a simulation executor 206, an image generator 207, and a collector 208. The controller 210 of Fig. 2 executes the image collection program, thereby implementing the functions of the image collection device 200. Part or all of the functions of the image collection device 200 may be implemented by hardware such as an electronic circuit.

The input image receiver 201 receives the input image from the user. In the present example, by drawing the shape of the break using the operation unit 250, the user can create two input images respectively corresponding to two different points in time in the period during which the abnormality occurs in the liquid process. The input image receiver 201 receives the two input images created by the user. Hereinafter, the two input images received by the input image receiver 201 are respectively referred to as a first input image and a second input image.

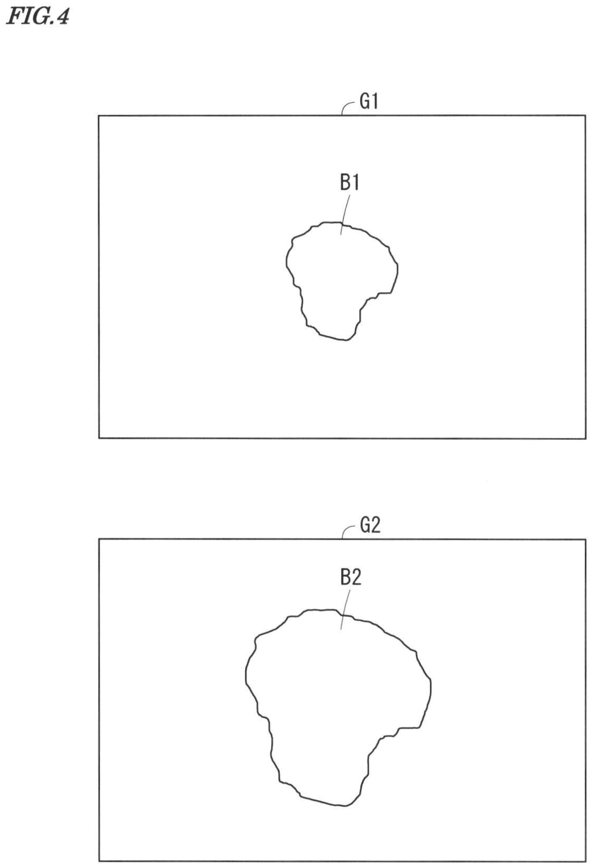

Fig. 4 is a diagram showing one example of input images. As shown in Fig. 4, the first input image G1 shows the shape of a break B1 at a first point in time in the period during which the abnormality occurs in the liquid process. A second input image G2 shows the shape of a break B2 at a second point in time in the period during which the abnormality occurs in the liquid process. The second point in time is later than the first point in time. The reference state identifier 202 identifies a reference state of the break B1 based on the first input image G1 received by the input image receiver 201.

The reference state of the break B1 includes a reference angle of the break B1, a reference position of the break B1, and a reference dimension of the break B1. The reference angle is the angle of the break B1 when the first input image G1 is received. The reference position is the position of the center of gravity of the break B1 when the first input image G1 is received. The reference dimension is the dimension of the break B1 when the first input image G1 is received.

The setting information receiver 203 receives various types of setting information for simulating the transition of the break. The user can input the setting information to the setting information receiver 203 by performing a predetermined operation using the operation unit 250. The setting information includes design information of a processor 120 of Fig. 1, a thickness of a liquid film, a spreading speed of a break, and the number of frames in a simulation. The design information of the processor 120 includes the shapes and dimensions of the spin chuck 121, the processing cup 123, the substrate W, and the like.

The designated range receiver 204 receives a range of state of the break B1 in the first input image G1 of Fig. 4. The user can input the range of state of the break B1 to the designated range receiver 204 by performing a predetermined operation using the operation unit 250. The state of the break B1 includes an angle of the break B1 when the reference angle is defined as 0 degrees, a reference position of the break B1 when the rotation center of the spin chuck 121 of Fig. 1 is defined as an origin, or a dimension (scale) of the break B1 with respect to the reference dimension.

The shape model generator 205, the simulation executor 206, and the image generator 207 are implemented by installing animation creation software such as Blender. Based on the design information of the processor 120 and the thickness of the liquid film received by the setting information receiver 203, the shape model generator 205 generates a three-dimensional shape model corresponding to the input image received by the input image receiver 201. Hereinafter, the shape model corresponding to the first input image is referred to as a first shape model, and a shape model corresponding to the second input image is referred to as a second shape model.

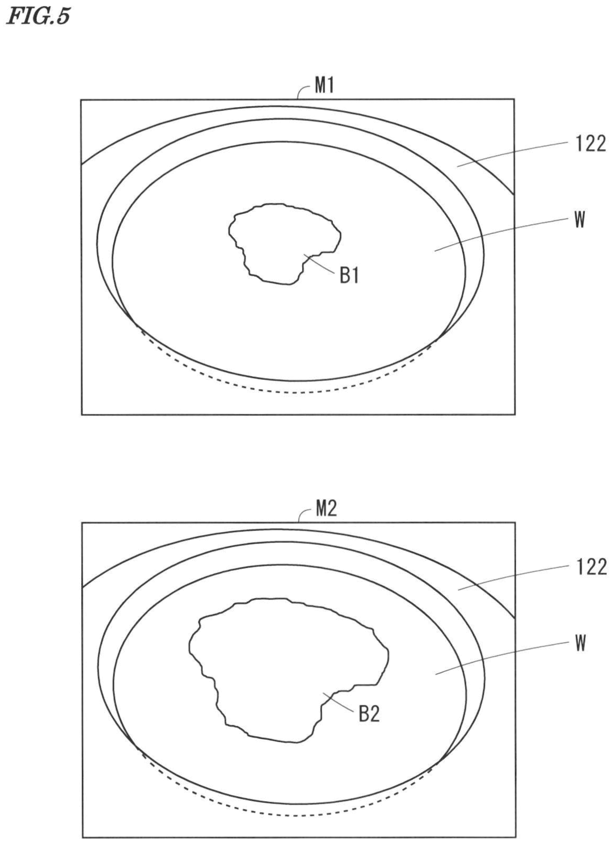

Fig. 5 is a diagram showing one example of the shape models. As shown in Fig. 5, the first shape model M1 shows the three-dimensional shapes of the substrate W held by the spin chuck 121, the processing cup 123 surrounding the substrate W, and the break B1 on the upper surface of the substrate W. The second shape model M2 shows the three-dimensional shapes of the substrate W held by the spin chuck 121, the processing cup 123 surrounding the substrate W, and the break B2 on the upper surface of the substrate W. In the example of Fig. 5, the breaks B1, B2 are arranged such that the reference positions of the breaks B1, B2 overlap with the rotation center of the spin chuck 121. Further, the angles of the breaks B1, B2 with respect to the reference angle are 0 degrees.

Based on the spreading speed of the break received by the setting information receiver 203, the simulation executor 206 simulates the transition of the break until the shape of the break B1 of the first shape model M1 becomes the shape of the break B2 of the second shape model M2. The transition of the break may be simulated by interpolating the shape between the shape of the break B1 and the shape of the break B2. Alternatively, the transition of the break may be simulated by a physics calculation based on fluid dynamics.

Further, based on the reference state of the break B1 identified by the reference state identifier 202, the simulation executor 206 randomly changes the state of the break B1 within the range received by the designated range receiver 204. Specifically, at least one of the angle, the position and the scale of the break B1 is changed. The simulation executor 206 simulates a spreading process of the break B1 the state of which has been changed. A similar simulation may be repeated while the state of the break B1 is further changed.

In the simulation executed by the simulation executor 206, the image generator 207 generates images showing shapes of the break in the course of transition. The number of images generated for each simulation is defined by the number of frames received by the setting information receiver 203. An animated video showing the course of simulation executed by the simulation executor 206 or images showing the transition of break generated by the image generator 207 can also be displayed on the display device 260.

The collector 208 collects the images generated by the image generator 207 as abnormal images. Specifically, the user confirms that the images generated by the image generator 207 show the shapes of the break when the abnormality occurs in the liquid process and annotates the images with a predetermined label using the operation unit 250, whereby the images are collected as the abnormal images. The above-mentioned labeling (annotation) may be automatically performed by the collector 208. The abnormal images collected by the collector 208 are provided to the training device 300 of Fig. 1.

### 3. Training Device and Abnormality Detection Device

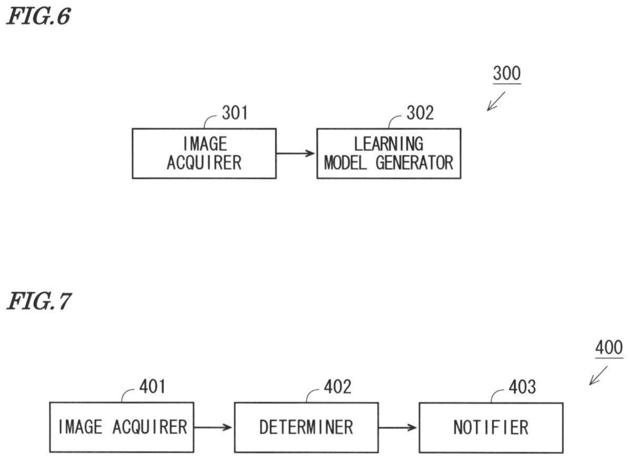

Fig. 6 is a block diagram showing the functional configuration of the training device 300. As shown in Fig. 6, the training device 300 includes an image acquirer 301 and a learning model generator 302 as functions. The functions of the training device 300 are implemented by execution of a training program by the controller of the training device 300. Part or all of the functions of the training device 300 may be realized by hardware such as an electronic circuit.

The image acquirer 301 acquires the abnormal images collected by the collector 208 of the image collection device 200 of Fig. 3. The learning model generator 302 generates a learning model for determining whether the shape of the break shown in the processing image generated by the imaging device 124 of Fig. 1 is abnormal by causing the untrained machine learning model to learn the abnormal images acquired by the image collection device 200. The generated learning model is installed in the abnormality detection device 400 by being stored in the storage device of the abnormality detection device 400, or the like.

Fig. 7 is a block diagram showing the functional configuration of the abnormality detection device 400. As shown in Fig. 7, the abnormality detection device 400 includes an image acquirer 401, a determiner 402, and a notifier 403 as functions. The functions of the abnormality detection device 400 are implemented by execution of a program by the controller of the abnormality detection device 400. Part or all of the functions of the abnormality detection device 400 may be realized by hardware such as an electronic circuit.

The image acquirer 401 acquires the processing image generated by the imaging device 124 from the controller 130 of Fig. 1. By using the learning model generated by the learning model generator 302 of the training device 300 of Fig. 6, the determiner 402 determines whether the shape of the break shown in the processing image acquired by the image acquirer 401 is abnormal. In a case in which the determiner 402 determines that the shape of the break is abnormal, the notifier 403 notifies the user that the abnormality has occurred in the liquid process.

As an example of a notification made by the notifier 403, a character string indicating that the abnormality has occurred in the liquid process may be displayed on the display device of the abnormality detection device 400, or the like. In a case in which the abnormality detection device 400 includes a sound output device, a sound indicating the similar contents may be output, or a warning sound such as a buzzer may be output. In a case in which the abnormality detection device 400 includes an indicator light such as a lamp, the indicator light may be turned on, turned off or blinked in a manner corresponding to the warning contents.

### 4. Image Collection Process

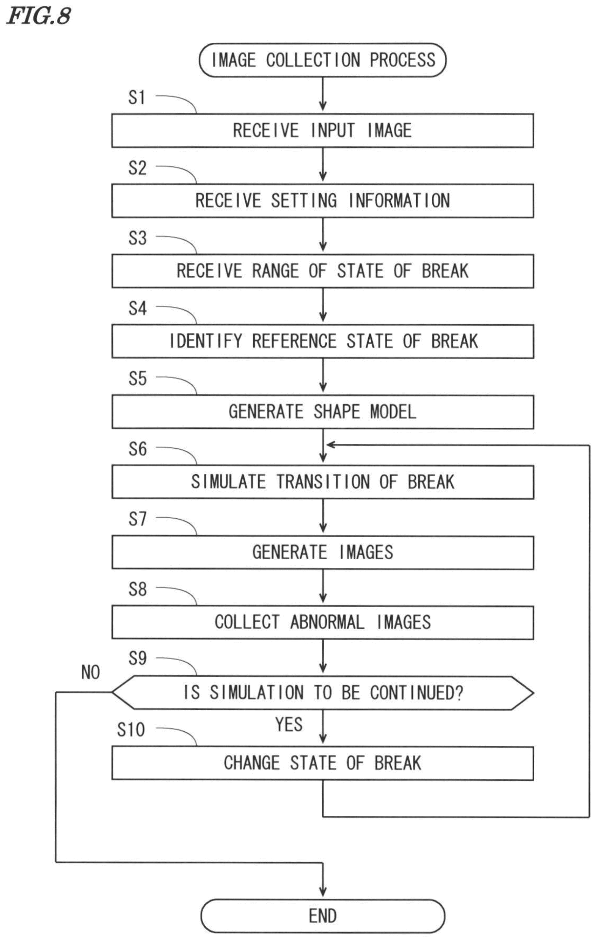

Fig. 8 is a flowchart showing one example of a flow of the image collection process. The image collection process is executed by the controller 210 of the image collection device 200 by execution of the image collection program by the controller 210. The image collection process of Fig. 8 will be described below with reference to the image collection device 200 of Fig. 3. First, the input image receiver 201 receives the input images (step S1). In the present example, the first input image and the second input image are received in the step S1.

Further, the setting information receiver 203 receives the setting information (step S2). In the present example, the design information of the processor 120 of Fig. 1, the thickness of the liquid film, the spreading speed of the break, and the number of frames in the simulation are received in the step S2. Further, the designated range receiver 204 receives the range of state of the break shown in the first input image (step S3). In the present example, at least one of the range of angle of the break, the range of position of the break, and the range of dimension of the break is received in the step S3.

Either one of the steps S1 and S3 may be performed first, or the steps S1 to S3 may be performed at the same time. Further, the reference state identifier 202 identifies the reference state of the break based on the first input image received in the step S1 (step S4). In the present example, the reference angle of the break, the reference position of the break, and the reference dimension of the break are identified in the step S4. The step S4 may be performed in conjunction with the step S1. Therefore, the step S4 may be performed before the step S2 or the step S3.

After the steps S1 to S4 end, based on the design information of the processor 120 and the thickness of the liquid film received in the step S2, the shape model generator 205 generates the three-dimensional shape model corresponding to the input image received in the step S1 (step S5). In the present example, the first shape model and the second shape model respectively corresponding to the first input image and the second input image are generated in the step S5.

Next, based on the spreading speed of the break received in the step S2, the simulation executor 206 simulates the transition of the break (step S6). Specifically, the transition of the break until the shape of the break of the first shape model generated in the step S3 becomes the shape of the break of the second shape model is simulated. Subsequently, in the simulation of the step S6, based on the number of frames received in the step S6, the image generator 207 generates the images showing the shapes of the break in the course of transition (step S7).

Thereafter, the collector 208 collects the images generated in the step S7 as the abnormal images (step S8). In the present example, among the images generated in the step S7, the annotated images are collected as the abnormal images. The annotation may be performed by the user or may be automatically performed by the collector 208. The collected abnormal images are provided to the training device 300 of Fig. 6.

Next, the collector 208 determines whether the simulation is to be continued (step S9). Based on a user instruction, the collector 208 may determine whether the simulation is to be continued. Alternatively, based on the number of abnormal images collected in the step S8, the collector 208 may determine whether the simulation is to be continued.

In a case in which it is determined that the simulation is to be continued, the simulation executor 206 randomly changes the state of the break in the first shape model within the range received in the step S3 based on the reference state of the break identified in the step S4 (step S10). In the present example, at least one of the angle, the position and the dimension of the break is changed in the step S10.

Thereafter, the process returns to the step S6. In this case, in the step S6, a spreading process of the break the state of which has been changed in the step S10 is simulated. The steps S6 to S10 are repeated until it is determined in the step S9 that the simulation is not to be continued. In a case in which it is determined that the simulation is not to be continued, the image collection process ends.

### 5. Training Process and Abnormality Detection Process

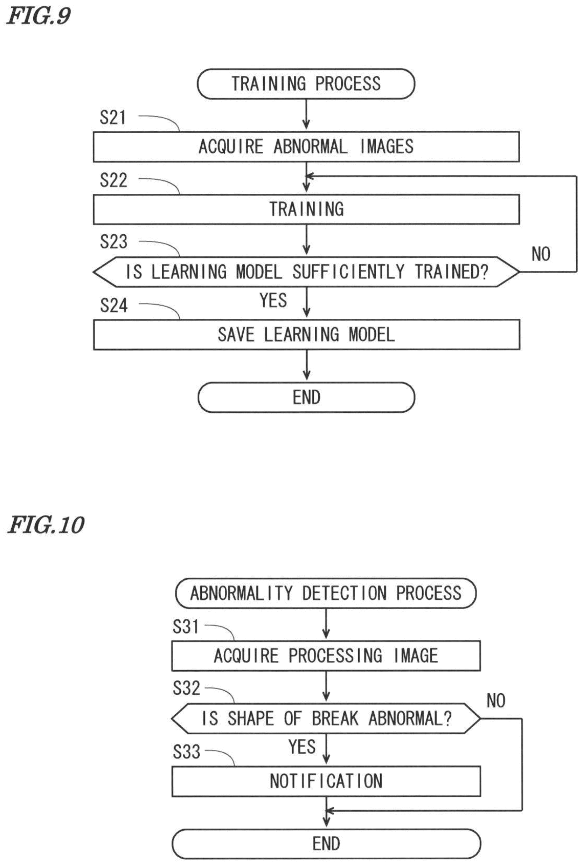

Fig. 9 is a flowchart showing one example of a flow of the training process. The training process is executed by the controller of the training device 300 by execution of the training program by the controller. The training process of Fig. 9 will be described below with reference to the training device 300 of Fig. 6. First, the image acquirer 301 acquires the abnormal images collected in the step S8 of the image collection process of Fig. 8 (step S21).

Next, the learning model generator 302 causes the untrained machine learning model to learn the abnormal images acquired in the step S21 (step S22). Subsequently, the learning model generator 302 determines whether the learning model has been sufficiently trained (step S23). In a case in which the learning model has not been sufficiently trained, the process returns to the step S22. Until the learning model is sufficiently trained, the steps S22 and S23 are repeated while parameters are changed. The number of repetitions of training changes according to a quality condition that the generated learning model is to satisfy.

In a case in which the learning model has been sufficiently trained, the learning model generator 302 saves the learning model generated as a result of the training in the step S22. Thus, the training process ends. In the step S24, the learning model may be saved by being stored in the storage device of the abnormality detection device 400 or the like. In this case, the generated learning model can be easily installed in the abnormality detection device 400.

Fig. 10 is a flowchart showing one example of a flow of the abnormality detection process. The abnormality detection process is executed in parallel with the substrate process by the controller of the abnormality detection device 400 by execution of the abnormality detection program by the controller. The abnormality detection process of Fig. 10 will be described below with reference to the abnormality detection device 400 of Fig. 7. First, in the substrate process, the image acquirer 401 acquires, from the controller 130, the processing image generated by the imaging device 124 of the processor 120 executing the substrate process among the plurality of processors 120 of Fig. 1 (step S31).

Next, the determiner 402 determines whether the shape of the break shown in the processing image acquired in the step S31 is abnormal using the learning model saved in the step S24 of the training process of Fig. 9 (step S32). In a case in which the shape of the break is not abnormal, the abnormality detection process ends. In a case in which the shape of the break is abnormal, the notifier 403 notifies the user that the abnormality has occurred in the liquid process (step S33). Thereafter, the abnormality detection process ends.

### 6. Effects

In the substrate processing apparatus 500 according to the present embodiment, the processing liquid is supplied to the substrate W by the processing nozzle 122 of the processing unit 100. The imaging device 124 generates the processing image showing the substrate W to which the processing liquid is supplied. Further, the abnormal images showing the states of the processing liquid on the substrate W when the abnormality occurs in the substrate process are collected by the image collection device 200. The abnormality detection device 400 detects the abnormality in the substrate process based on the comparison between the processing image and the abnormal images.

In the image collection device 200, the input image receiver 201 receives the first input image G1 showing the state of the processing liquid on the substrate W when the abnormality occurs in the substrate process. Based on the first input image G1, the shape model generator 205 generates the shape model representing the three-dimensional shape of the processing liquid supplied to the substrate W. The simulation executor 206 simulates the transition of state of the processing liquid in the shape model. The image generator 207 generates the images showing the transition of state of the processing liquid in the simulation. The collector 208 collects the generated images as the abnormal images.

With this configuration, by inputting the first input image G1 to the input image receiver 201, it is possible to generate a large number of images showing the states of the processing liquid on the substrate W when the abnormality occurs in the substrate process. Thus, it is possible to efficiently collect the abnormal images. As a result, it is possible to improve accuracy of detecting the abnormality in the substrate process executed using the processing liquid.

Collecting the abnormal images further includes receiving, by the input image receiver 201, the second input image G2 showing the state of the processing liquid on the substrate when the abnormality occurs in the substrate process. Further, simulating the transition of state of the processing liquid includes simulating the transition of state of the processing liquid between the processing liquid shown in the first input image G1 and the processing liquid shown in the second input image G2. In this case, the image generator 207 generates no image showing the state of the processing liquid when the substrate process is executed normally. This reduces a workload required to check a generated image. Further, it facilitates automatic annotation of the generated image. Thus, the abnormal images can be easily collected.

Receiving the first input image G1 and the second input image G2 includes receiving the drawings of the first input image G1 and the second input image G2 provided by the user of the substrate processing apparatus 500. In this case, the user of the substrate processing apparatus 500 can easily input the first input image G1 and the second input image G2 to the input image receiver 201 by drawing.

The simulation executor 206 changes the state of the processing liquid shown in the first input image G1, and further simulates the transition of the state of the processing liquid after the state is changed. In this case, it is possible to generate a larger number of images showing the states of the processing liquid on the substrate W when the abnormality occurs in the substrate process. Thus, it is possible to efficiently collect the abnormal images. Changing the state of the processing liquid includes changing at least one of the position, the angle, and the scale of a specific area in the processing liquid. In this case, the state of the processing liquid can be easily changed.

In the present example, the processing liquid is IPA. In this case, it is possible to easily collect the abnormal images for detecting the abnormality in the process of cleaning the substrate W. Further, collecting the abnormal images showing the states of the processing liquid includes collecting the abnormal images showing the break of IPA. In this case, it is possible to easily collect the abnormal images for detecting the abnormality in the substrate process during the step of drying the substrate W.

Further, in the present example, the training device 300 generates, using the collected abnormal images, the learning model for determining whether the state of the processing liquid is abnormal. In the abnormality detection device 400, the image acquirer 401 acquires the processing image generated by any one of the imaging devices 124. Based on the learning model generated by the training device 300, the determiner 402 determines whether the state of the processing liquid shown in the processing image acquired by the image acquirer 401 is abnormal. **In** this case, it is possible to easily detect the abnormality in the substrate process using the learning model.

### 7. Other Embodiments

(1) While the input image receiver 201 receives the two input images in the above-mentioned embodiment, the embodiment is not limited to this. The input image receiver 201 may receive only one input image. For example, in a case in which only the first input image G1 is received, the simulation executor 206 may simulate the transition of the break B1 over time, that is, the spreading process of the break B1. On the other hand, in a case in which only the second input image G2 is received, the simulation executor 206 may simulate a transition backward in time, that is, a shrinking process of the break B2. These simulations are executed by a physics calculation based on fluid dynamics, for example.
(2) While the input image is created by drawing by the user in the above-mentioned embodiment, the embodiment is not limited to this. The input image may be an actual image showing a state of the processing liquid on the substrate when the abnormality occurs in the substrate process and may be generated by the storage device 240 through imaging.
(3) While the range of state of the break B1 is received and the spreading process of the break B1 the state of which has been changed is simulated in the above-mentioned embodiment, the embodiment is not limited to this. The range of state of the break B2 may be received, and a shrinking process of the break B2 the state of which has been changed may be simulated.

Further, in a case in which a sufficient number of abnormal images can be collected by the simulation of transition of the break before the state is changed, the transition of the break after the state is changed (the steps S9 and S10 of the image collection process) does not have to be simulated. Further, the image collection device 200 does not have to include the designated range receiver 204, and the step S3 of the image collection process does not have to be executed.

(4) While the determiner 402 of the abnormality detection device 400 determines, using the learning model, whether the state of the processing liquid shown in the processing image is abnormal in the above-mentioned embodiment, the embodiment is not limited to this. The determiner 402 may determine, without using the learning model, whether the state of the processing liquid shown in the processing image is abnormal based on the similarity or dissimilarity between the processing image and the abnormal images. In this case, the abnormal images collected by the image collection device 200 are provided to the determiner 402. Therefore, the substrate processing apparatus 500 does not have to include the training device 300.

(5) While the state of the processing liquid is the state of the break (dry area) of the processing liquid in the above-mentioned embodiment, the embodiment is not limited to this. The state of the processing liquid may be another state such as a state of an applied area of the processing liquid. Further, the processing liquid is not limited to IPA, and may be another cleaning liquid, a coating liquid, a development liquid, an etching liquid, or the like.

### 8. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate W is an example of a substrate, the processing nozzle 122 is an example of a processing nozzle, the imaging device 124 is an example of an imaging device, and the first input image G1 is an example of a first input image. The input image receiver 201 is an example of an input image receiver, the shape model generator 205 is an example of a shape model generator, and the simulation executor 206 is an example of a simulation executor. The image generator 207 is an example of an image generator, the collector 208 is an example of a collector, the determiner 402 is an example of an abnormality detector, and the substrate processing apparatus 500 is an example of a substrate processing apparatus.

### 9. Overview of Embodiments

(Item 1) A substrate processing method according to item 1 executed in a substrate processing apparatus, includes supplying a processing liquid to a substrate using a processing nozzle, generating, using an imaging device, a processing image showing the substrate to which the processing liquid is supplied, collecting an abnormal image showing a state of the processing liquid on the substrate when an abnormality occurs in a substrate process, and detecting the abnormality in the substrate process based on a comparison between the processing image and the abnormal image, wherein the collecting an abnormal image is executed by a processor, and the substrate processing method includes receiving a first input image showing a state of the processing liquid on the substrate when the abnormality occurs in the substrate process, generating, based on the first input image, a shape model representing a three-dimensional shape of the processing liquid supplied to the substrate, simulating a transition of the state of the processing liquid in the shape model, generating an image showing the transition of the state of the processing liquid in a simulation, and collecting the generated image as the abnormal image.

With this substrate processing method, the processing image showing the substrate to which the processing liquid is supplied by the processing nozzle is generated by the imaging device. Further, the abnormal images showing the states of the processing liquid on the substrate when the abnormality occurs in the substrate process are collected. The abnormality in the substrate process is detected based on the comparison between the processing image and the abnormal images.

In the collection of the abnormal images, the first input image showing the state of the processing liquid on the substrate when the abnormality occurs in the substrate process is received. Based on the first input image, the shape model representing the three-dimensional shape of the processing liquid supplied to the substrate is generated. The transition of state of the processing liquid in the shape model is simulated. The images showing the states of the processing liquid transitioning in the simulation are generated. The generated images are collected as the abnormal images.

In this case, by inputting the first input image, it is possible to generate a large number of images showing the states of the processing liquid on the substrate when the abnormality occurs in the substrate process. Thus, it is possible to efficiently collect the abnormal images. As a result, it is possible to improve accuracy of detecting the abnormality in the substrate process executed using the processing liquid.

(Item 2) The substrate processing method according to item 1, wherein the collecting an abnormal image further includes receiving a second input image showing a state of the processing liquid on the substrate when the abnormality occurs in the substrate process, and the simulating a transition of the state of the processing liquid includes simulating a transition between the state of the processing liquid shown in the first input image and the state of the processing liquid shown in the second input image.

In this case, no image showing the state of the processing liquid when the substrate process is executed normally is generated. Thus, it is possible to easily collect the abnormal images.

(Item 3) The substrate processing method according to item 1 or 2, wherein the receiving a first input image includes receiving a drawing of the first input image provided by a user of the substrate processing apparatus.

In this case, the user of the substrate processing apparatus can easily input the first input image by drawing.

(Item 4) The substrate processing method according to any one of items 1 to 3, wherein the collecting an abnormal image further includes changing the state of the processing liquid shown in the first input image, and simulating a transition of the state of the processing liquid after the state is changed.

In this case, it is possible to generate a larger number of images showing the states of the processing liquid on the substrate W when the abnormality occurs in the substrate process. Thus, it is possible to efficiently collect the abnormal images.

(Item 5) The substrate processing method according to item 4, wherein the changing the state of the processing liquid includes changing at least one of a position, an angle, and a scale of a specific area of the processing liquid.

In this case, the state of the processing liquid can be easily changed.

(Item 6) The substrate processing method according to any one of items 1 to 5, wherein the collecting an abnormal image showing a state of the processing liquid includes collecting an abnormal image showing a state of a dry area of the processing liquid.

In this case, it is possible to easily collect the abnormal images for detecting the abnormality in the substrate process during the step of drying the substrate.

(Item 7) The substrate processing method according to any one of items 1 to 6, wherein the processing liquid includes isopropyl alcohol.

In this case, it is possible to easily collect the abnormal images for detecting the abnormality in the substrate cleaning process.

(Item 8) The substrate processing method according to any one of items 1 to 7, further includes generating, using the collected abnormal image, a learning model for determining whether a state of the processing liquid is abnormal, wherein the detecting the abnormality in the substrate process includes determining, based on the learning model, whether a state of the processing liquid shown in the processing image is abnormal.

In this case, it is possible to easily detect the abnormality in the substrate process using the learning model.

(Item 9) An image collection method according to a ninth item of collecting, using a processor, an abnormal image for detecting an abnormality in a substrate process executed using a processing liquid, includes receiving a first input image showing a state of the processing liquid when an abnormality occurs in the substrate process, the processing liquid being supplied to a substrate, generating, based on the first input image, a shape model representing a three-dimensional shape of the processing liquid supplied to the substrate, simulating a transition of the state of the processing liquid in the shape model, generating an image showing the transition of the state of the processing liquid in a simulation, and collecting the generated image as the abnormal image.

With this image collection method, by inputting the first input image, it is possible to generate a large number of images showing the states of the processing liquid on the substrate when the abnormality occurs in the substrate process. Thus, it is possible to efficiently collect the abnormal images.

(Item 10) A substrate processing program according to a tenth item executed in a substrate processing apparatus, causes a processor to supply a processing liquid to a substrate using a processing nozzle, generate, using an imaging device, a processing image showing the substrate to which the processing liquid is supplied, collect an abnormal image showing a state of the processing liquid on the substrate when an abnormality occurs in a substrate process, and detect the abnormality in the substrate process based on a comparison between the processing image and the abnormal image, wherein the causing a processor to collect an abnormal image includes causing the processor to receive a first input image showing a state of the processing liquid on the substrate when the abnormality occurs in the substrate process, generate, based on the first input image, a shape model representing a three-dimensional shape of the processing liquid supplied to the substrate, simulate a transition of the state of the processing liquid in the shape model, generate an image showing the transition of the state of the processing liquid in a simulation, and collect the generated image as the abnormal image.

With this substrate processing program, by inputting the first input image, it is possible to generate a large number of images showing the states of the processing liquid on the substrate when the abnormality occurs in the substrate process. Thus, it is possible to efficiently collect the abnormal images. As a result, it is possible to improve accuracy of detecting the abnormality in the substrate process executed using the processing liquid.

(Item 11) A substrate processing apparatus according to an eleventh item includes a processing nozzle that supplies a processing liquid to a substrate, an imaging device that generates a processing image showing the substrate to which the processing liquid is supplied, an input image receiver that receives a first input image showing a state of the processing liquid on the substrate when an abnormality occurs, a shape model generator that generates, based on the first input image, a shape model representing a three-dimensional shape of the processing liquid supplied to the substrate, a simulation executor that simulates a transition of the state of the processing liquid in the shape model, an image generator that generates an image showing the transition of the state of the processing liquid in a simulation, a collector that collects the generated image as an abnormal image, and an abnormality detector that detects the abnormality in the substrate process based on a comparison between the processing image and the abnormal image.

In this substrate processing apparatus, by inputting the first input image, it is possible to generate a large number of images showing the states of the processing liquid on the substrate when the abnormality occurs in the substrate process. Thus, it is possible to efficiently collect the abnormal images. As a result, it is possible to improve accuracy of detecting the abnormality in the substrate process executed using the processing liquid.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A substrate processing method executed in a substrate processing apparatus, including:
supplying a processing liquid to a substrate using a processing nozzle;
generating, using an imaging device, a processing image showing the substrate to which the processing liquid is supplied;
collecting an abnormal image showing a state of the processing liquid on the substrate when an abnormality occurs in a substrate process; and
detecting the abnormality in the substrate process based on a comparison between the processing image and the abnormal image, wherein
the collecting an abnormal image is executed by a processor, and
the substrate processing method includes
receiving a first input image showing a state of the processing liquid on the substrate when the abnormality occurs in the substrate process,
generating, based on the first input image, a shape model representing a three-dimensional shape of the processing liquid supplied to the substrate,
simulating a transition of the state of the processing liquid in the shape model,
generating an image showing the transition of the state of the processing liquid in a simulation, and
collecting the generated image as the abnormal image.

2. The substrate processing method according to claim 1, wherein
the collecting an abnormal image further includes receiving a second input image showing a state of the processing liquid on the substrate when the abnormality occurs in the substrate process, and
the simulating a transition of the state of the processing liquid includes simulating a transition between the state of the processing liquid shown in the first input image and the state of the processing liquid shown in the second input image.

3. The substrate processing method according to claim 1 or 2, wherein
the receiving a first input image includes receiving a drawing of the first input image provided by a user of the substrate processing apparatus.

4. The substrate processing method according to any one of claims 1 to 3, wherein
the collecting an abnormal image further includes changing the state of the processing liquid shown in the first input image, and
simulating a transition of the state of the processing liquid after the state is changed.

5. The substrate processing method according to claim 4, wherein
the changing the state of the processing liquid includes changing at least one of a position, an angle, and a scale of a specific area of the processing liquid.

6. The substrate processing method according to any one of claims 1 to 5, wherein
the collecting an abnormal image showing a state of the processing liquid includes collecting an abnormal image showing a state of a dry area of the processing liquid.

7. The substrate processing method according to any one of claims 1 to 6, wherein
the processing liquid includes isopropyl alcohol.

8. The substrate processing method according to any one of claims 1 to 7, further including generating, using the collected abnormal image, a learning model for determining whether a state of the processing liquid is abnormal, wherein
the detecting the abnormality in the substrate process includes determining, based on the learning model, whether a state of the processing liquid shown in the processing image is abnormal.

9. An image collection method of collecting, using a processor, an abnormal image for detecting an abnormality in a substrate process executed using a processing liquid, including:
receiving a first input image showing a state of the processing liquid when an abnormality occurs in the substrate process, the processing liquid being supplied to a substrate;
generating, based on the first input image, a shape model representing a three-dimensional shape of the processing liquid supplied to the substrate;
simulating a transition of the state of the processing liquid in the shape model;
generating an image showing the transition of the state of the processing liquid in a simulation; and
collecting the generated image as the abnormal image.

10. A substrate processing program executed in a substrate processing apparatus, causing a processor to
supply a processing liquid to a substrate using a processing nozzle;
generate, using an imaging device, a processing image showing the substrate to which the processing liquid is supplied;
collect an abnormal image showing a state of the processing liquid on the substrate when an abnormality occurs in a substrate process; and
detect the abnormality in the substrate process based on a comparison between the processing image and the abnormal image, wherein
the causing a processor to collect an abnormal image includes causing the processor to
receive a first input image showing a state of the processing liquid on the substrate when the abnormality occurs in the substrate process,
generate, based on the first input image, a shape model representing a three-dimensional shape of the processing liquid supplied to the substrate,
simulate a transition of the state of the processing liquid in the shape model,
generate an image showing the transition of the state of the processing liquid in a simulation, and
collect the generated image as the abnormal image.

11. A substrate processing apparatus comprising:
a processing nozzle that supplies a processing liquid to a substrate;
an imaging device that generates a processing image showing the substrate to which the processing liquid is supplied;
an input image receiver that receives a first input image showing a state of the processing liquid on the substrate when an abnormality occurs;
a shape model generator that generates, based on the first input image, a shape model representing a three-dimensional shape of the processing liquid supplied to the substrate;
a simulation executor that simulates a transition of the state of the processing liquid in the shape model;
an image generator that generates an image showing the transition of the state of the processing liquid in a simulation;
a collector that collects the generated image as an abnormal image; and
an abnormality detector that detects the abnormality in the substrate process based on a comparison between the processing image and the abnormal image.
